Europäisches Patentamt

European Patent Office

Office européen des brevets

(19)

(11) Publication number : **0 520 713 A2**

(12) **EUROPEAN PATENT APPLICATION**

(21) Application number : **92305686.5**

(22) Date of filing : **22.06.92**

(51) Int. Cl.$^5$ : **H01L 21/336**

(30) Priority : **24.06.91 US 720073**

(43) Date of publication of application :
**30.12.92 Bulletin 92/53**

(84) Designated Contracting States :
**DE FR GB IT NL SE**

(71) Applicant : **GENERAL ELECTRIC COMPANY**
**1 River Road**
**Schenectady, NY 12345 (US)**

(72) Inventor : **Possin, George Edward**
**2351 Algonquin Road**
**Schenectady, New York 12309 (US)**

(74) Representative : **Lupton, Frederick**
**LONDON PATENT OPERATION, G.E.**
**TECHNICAL SERVICES Co. INC., Essex**
**House, 12/13 Essex Street**
**London WC2R 3AA (GB)**

(54) **Process for thin film transistor device fabrication with reduced number of mask steps.**

(57) The process of fabricating an inverted staggered thin film transistor having a source/drain region formed from a layer of doped silicon atop a layer of intrinsic silicon and having a source/drain contact configuration atop the layer of doped silicon is simplified, and the number of masking steps required is reduced, by patterning the intrinsic silicon and doped silicon layers until after patterning the source/drain metallization layer to form the source/drain contact configuration and an associated access electrode configuration, and then using the patterned electrode metallization layer as a mask for etching the silicon layers.

## FIG. 3

## Related Applications and Patents

The present application is related to:-
**European Application No. 91920064.2** (our ref: RD-19511) entitled, "Thin Film Transistor Structure for Uniform characteristics Across a Wafer and Method of Fabrication", by R.F. Kwasnick, et al.;
**PCT Publication No. WO92/06490** (our ref: RD-19584) based on U.S. Application Serial No. 07/593,425, filed October 5, 1990, entitled "Device Self-Alignment by Propagation of a Reference Structure's Topography", by C-Y Wei, et al;
**PCT Publication No. WO92/06497** (our ref: RD-19597) based on U.S. Serial No. 07/593,423, filed October 5, 1990, entitled, "Positive Control of the Source/Drain-Gate Overlap in Self-Aligned TFTs Via a Top Hat Gate Electrode Configuration", by C-Y Wei, et al;
**European Application No. 91919583.4** based on U.S. Serial No. 07/593,421, filed October 5, 1990, entitled, "Thin film Transistor Having an Improved Gate Structure and Gate Coverage by the Gate Dielectric" by F.F. Kwasnick, et al;
**European Application, Publication No. 0453169** (our ref: RD-19596), entitled "Method for Photolithographically Forming a Self-Aligned Mask Using Back Side Exposure and a Non-Specular Reflecting Layer", by G.E. Possin, et al; and
**U.S. Patent No. 5,010,027,** issued April 23, 1991, entitled "Method for Fabricating a Self-Aligned Thin-Film Transistor Utilizing Planarization and Back-Side Photoresist Exposure", by G.E. Possin, et al.,
each of which is assigned to General Electric Company and incorporated by reference.

## Field of the Invention

The present invention relates to the field of thin film transistor devices, and more particularly, to the field of inverted staggered thin film transistors.

## Background Information

Amorphous silicon (a-Si) thin film transistors (TFT's) are used in a number of applications such as flat panel displays, imaging devices, and printhead drivers.

Inverted staggered thin film transistors have a gate electrode structure disposed on a substrate, a layer of gate dielectric disposed over the gate electrode, substantially intrinsic amorphous silicon semiconductor material disposed on top of the gate electrode, and doped amorphous silicon disposed on top of the intrinsic amorphous silicon, at least in the vicinity of the channel region where the source and drain metallization contacts the semiconductor material. The channel portion of the semiconductor material is free of doped silicon and is normally passivated with what is referred to as a back channel passivation layer.

A common prior art process for fabricating a TFT involves at least five masking steps, including separate steps for patterning the intrinsic silicon and doped silicon layers, which steps require the use of separate masks. For example, a typical process includes forming a gate electrode on a substrate, which involves at least one masking step. The next steps include depositing a gate dielectric layer, depositing intrinsic amorphous silicon over the gate dielectric, and depositing a second dielectric layer over the intrinsic silicon. Typically, both of these dielectric layers are silicon nitride (SiN). The upper silicon nitride dielectric layer is then patterned with the use of another mask to be retained only on the channel portion of the TFT. A layer of $n^+$ amorphous silicon is then deposited on the structure with the result that it covers all of the intrinsic amorphous silicon except that portion still covered by the remaining portion of the upper dielectric layer. Optionally, a molybdenum capping layer 100 to 1000Å thick is deposited on top of the $n^+$ silicon to protect the $n^+$ surface. A layer of photoresist is then deposited on the structure and patterned with the use of another mask in the pattern desired for the amorphous silicon layers and the molybdenum capping layer; the silicon material is then etched around the mask. Via holes to make contact to the gate electrode structure may optionally be patterned with a fourth mask of photoresist and etched through the lower silicon nitride layer to expose the gate metallization. Thereafter, the source/drain electrode metallization layer is deposited.

Next, a planarization layer is formed over the entire structure and etched back uniformly until the upper dielectric layer (SiN) is exposed over the channel region, allowing the planarization layer to serve as a fifth mask in the etching to form the source/drain contact configuration in the channel area of the TFT. Another photoresist layer is deposited on the structure and patterned with a sixth mask in accordance with the desired pattern for the associated access electrode configuration which is then etched in an appropriate etchant. Thereafter, the $n^+$ amorphous silicon exposed by the patterning of the source/drain metallization is etched off.

This prior art fabrication process is fairly lengthy, and requires at least five photoresist masking steps and a number of deposition steps. Any reduction in the complexity of this process or the number of masking steps will increase yield and reduce processing costs.

The invention as disclosed in this application can also be applied to versions of the TFT fabrication process in which the source/drain electrodes are aligned to the gate and top dielectric by a conventional photolithographic alignment process instead of by a planarization process.

## Objects of the Invention

Accordingly, one object of the present invention is to reduce the complexity of the process for fabricating an inverted staggered thin film transistor device.

Another object of the present invention is to reduce the number of masking steps required in forming an inverted staggered thin film transistor device.

## Summary of the Invention

In the present invention the patterning of at least the intrinsic silicon conductor layer and the doped amorphous silicon contact layer is delayed until after the source/drain electrode metallization layer has been patterned, and the patterned electrode layer thus produced is used as a mask in the etching of the silicon layer. The process of this invention thus eliminates a separate photomasking step and associated etching steps to pattern the silicon layers. The overall TFT fabrication process is thus simplified, as fewer masks are required.

The process of the present invention for fabricating a thin film transistor device structure includes the steps of forming a gate electrode on a substrate; depositing a first dielectric layer over the gate and the substrate; depositing a semiconductor layer, preferably of substantially intrinsic silicon, over the first dielectric layer; depositing a second dielectric layer over the semiconductor layer; patterning the second dielectric layer to leave a remaining portion that will be used to define a source/drain electrode gate overlap area; depositing a doped silicon contact layer over the wafer; depositing an electrode metallization layer; forming a source/drain contact configuration and an associated access electrode configuration in the electrode metallization layer; and, using the configured electrode metallization layer as a mask, etching the now-exposed areas of the intrinsic silicon semiconductor layer and the doped silicon contact layer.

This process results in fewer masking and etching steps while still providing effective TFT structures for use with imagers or display systems. For liquid crystal display applications in which the source/drain electrode configuration must be electrically coupled to a transparent conducting oxide (TCO) electrode, it is preferable to deposit the TCO layer after the last step of the process set out above, thus allowing deposition of the TCO on the wafer without any underlying silicon layers. In such a process, the configured source/drain electrode metallization layer, the $n^+$ amorphous silicon contact layer and the intrinsic amorphous silicon semiconductor layer are etched with a process that provides a substantially contiguous sloped sidewall extending from the source/drain electrodes formed in the configured electrode metallization layer to the layer underlying the semiconductor layer, thus allowing the TCO deposited to extend up the sloped sidewall to the source/drain electrode to ensure good electrical coupling.

## Brief Description of the Drawings

The features of the invention believed to be novel are set forth with particularity in the appended claims. The invention itself together with further objects and advantages thereof may best be understood by reference to the following description taken in conjunction with the accompanying drawings in which like characters represent like characters throughout the drawings, and:

Figures 1(A)-1(I) illustrate cross sectional views of successive stages in the fabrication of a thin film transistor in accordance with the present invention;

Figure 2 is a plan view of a thin film transistor fabricated in accordance with this invention.

Figure 3 illustrates in a cross sectional view the present invention in an imaging device having a thin transparent conducting oxide electrode extending onto the source/drain electrode.

## Detailed Description

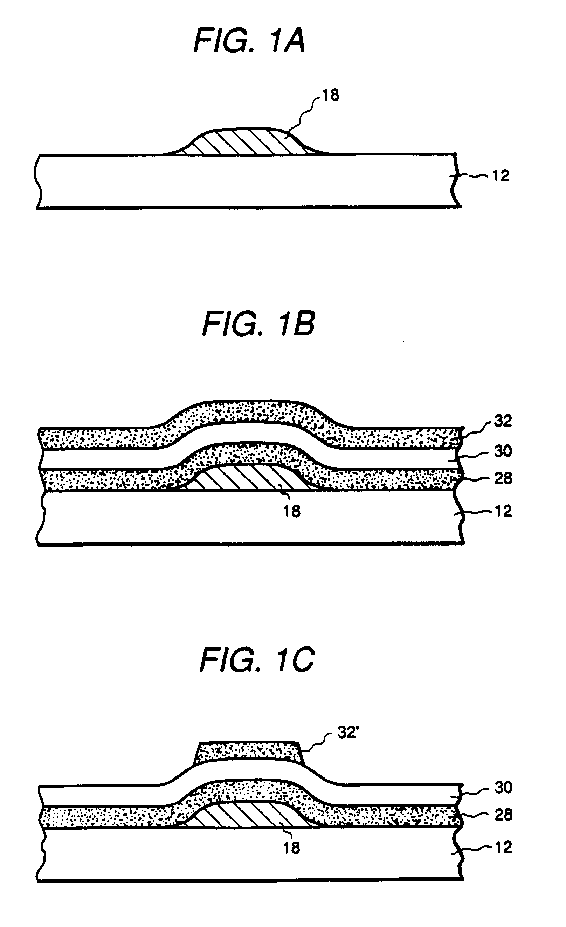

In Figure 1(A), a portion of a substrate 12 which forms the base on which one or more thin film transistor devices are to be fabricated is illustrated in cross-section. Substrate 12 is formed of an insulative and preferably transparent material, such as glass or the like. The process of fabricating thin film transistor device structures in accordance with the present invention begins by forming a gate electrode 18 on substrate 12. As used herein, "structure" refers to the arrangement of all the materials used in the fabrication of the TFT existing on substrate 12 at any given time during or after completion of the fabrication process.

Gate electrode 18 may be a single electrically conductive layer of a metal such as titanium (Ti), chromium (Cr), tungsten (W), aluminum (Al) and the like, or the gate electrode may be a multilayer structure, such as molybdenum over chromium (Mo/Cr), titanium over molybdenum (Ti/Mo), titanium over aluminum (Ti/Al), or the like, to provide a gate electrode structure that adheres well to substrate 12 and that demonstrates low electrical resistance.

Formation of gate electrode 18 typically involves steps of depositing one or more gate metallization layers and then patterning the gate metallization layers. Patterning of gate electrode 18 preferably produces a structure as illustrated in Figure 1(A) that has sloped sidewalls, which provide improved structural integrity for the device. As used herein, the term "sloped sidewalls" refers to sidewalls having a substantially uniform taper from the top of the layer to the bottom of the layer. The slope of the taper may be selected for good bonding with a subsequently deposited layer, such as 45 degrees. As used herein, patterning refers to the selective shaping of the structure of the TFT device, and typically comprises the steps of depositing a layer of photoresist over the layer or portion of the TFT device to be shaped; exposing the photoresist to actinic radiation in accordance with a desired pattern; developing the photoresist so that the photoresist retained on the device structure provides the selected pattern for etching the underlying structure; and etching the underlying structure not covered by the photoresist using known wet or dry etching techniques Typically the remaining photoresist is then removed, however it may be retained for use in a subsequent step if it advantageous to do so.

Next, as illustrated in Figure 1(B), a gate dielectric layer 28 is deposited over the entire structure by a process which is known to produce a high integrity dielectric, such as plasma enhanced chemical vapor deposition (PECVD). This gate dielectric layer is deposited to a thickness between about 100 nm and 600 nm, and preferably comprises silicon nitride, but may be silicon dioxide or another suitable dielectric. The sloped sidewall of gate electrode 18 enables the deposition of a high integrity conformal dielectric layer.

A semiconductor layer 30 of intrinsic amorphous silicon (i-Si) or the like is deposited on gate dielectric layer 28. Semiconductor layer 30 is preferably deposited to a thickness of between about 200 and 5000Å by known techniques, such as plasma enhanced vapor deposition (PECVD). Next, a second dielectric layer 32 is deposited by a known technique, such as CVD, over semiconductor layer 30. Second dielectric layer 32 is preferably silicon nitride deposited to a thickness between about 1,000 and 10,000Å, but may alternatively be silicon dioxide or another suitable dielectric. At this stage the structure cross-section appears as shown in Figure 1(B).

Second dielectric layer 32 is then patterned to define a source/drain electrode overlap area. As used herein, "define" refers to determining or fixing the boundaries or extent of an area or part of the TFT structure. Patterning of second dielectric layer 32 may be performed using self alignment techniques, such as are described in previously-cited U.S. Patent No. 5,010,027. As appears in Figure 1(C), after patterning the remaining portion of second dielectric layer 32 forms a channel plug 32' that is disposed substantially above gate electrode 18 in an area that will be the channel region of the completed TFT.

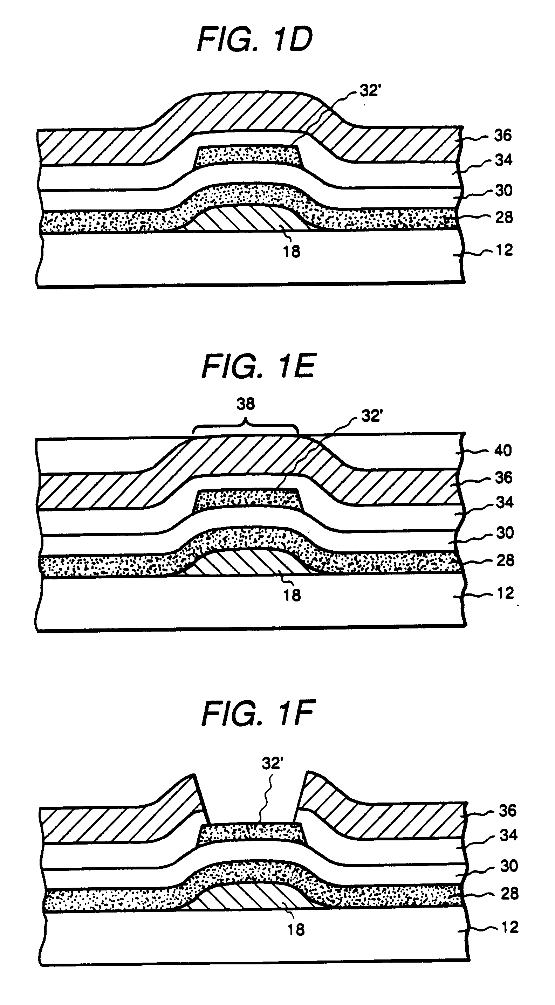

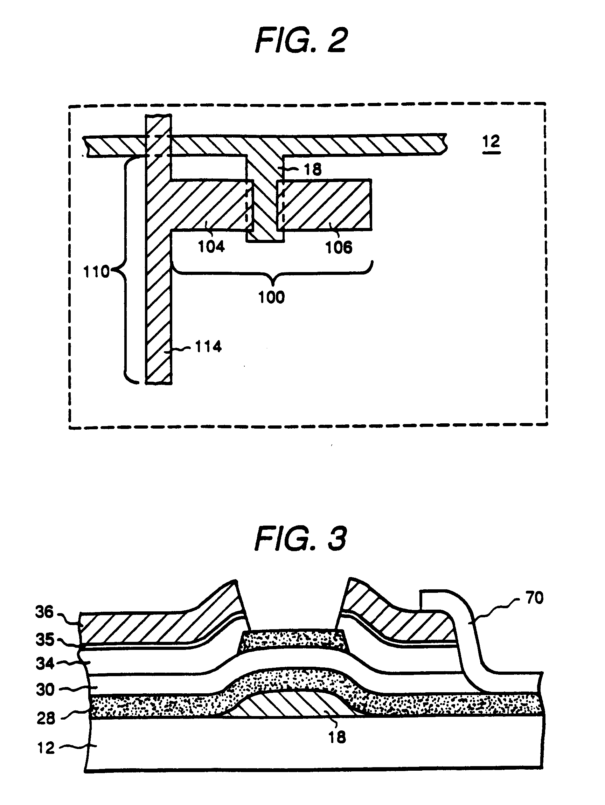

Next, a doped silicon contact layer 34 of $n^+$ amorphous silicon is deposited over the structure to a thickness in the range of about 100 to 1000Å. Doped silicon contact layer 34 covers exposed portions of the i-Si semiconductor layer 30 and channel plug 32'. If desired, an optional thin molybdenum capping layer 35 (Figure 3) can then deposited over the doped silicon contact layer to protect the $n^+$ amorphous silicon surface from contamination by subsequently deposited photoresist. If applied, this capping layer will be etched at substantially the same times and in substantially the same areas that electrode metallization layer 36 (Figure 1(D)) is etched, as described below.

An electrode metallization layer 36 is then deposited over the structure. Electrode metallization layer may be a contact metal, such as molybdenum, chromium, or the like, and is typically deposited by known methods, such as sputtering, to a thickness between about 100 nm and about 500nm. Alternatively, a two layer electrode metallization layer (not shown) may be deposited, comprising a first relatively thin layer of chromium, nichrome, tantalum or other appropriate metals which make good ohmic contact to $n^+$ amorphous silicon, and a relatively thick layer of a second conductor such as molybdenum, aluminum, tungsten or other appropriate metals. After this step, the structure of the device is as illustrated in Figure 1(D).

Next, a source/drain contact configuration 100 (Figure 2) and an associated access electrode configuration 110 are defined in electrode metallization layer 36 (Figure 1(D)). Defining source/drain contact configuration 100 (Figure 2) results in the positioning of the source electrode 104 and drain electrode 106 of the TFT device overlapping gate electrode 18 by a selected amount so that an effective transistor device is made. Defining access electrode configuration 110 results in an access electrode 114 that provides a path by which signals are conducted to or from the source/drain electrodes of the TFTs fabricated on the wafer.

Source/drain contact configuration 100 (Figure 2) and access electrode configuration 110 may be defined either by photolithographic patterning techniques, or by planarization techniques as described below. If photolithographic patterning techniques are used, one mask can be used to expose a layer of photoresist to pattern both source/drain contact configuration 100 and access electrode configuration 110. While this process accomplishes the patterning of all of the electrode metallization layer with one mask, this photolithographic patterning technique does not provide as fine control over the positioning of the source and drain electrodes in the channel area above the gate, which positioning is critical to device performance.

In the planarization process, a planarization layer 40 (Figure 1(E))(which may be photoresist) is deposited over the entire structure to cover all exposed portions of the electrode metallization layer and to provide a substantially planar upper surface on the structure. The planarization layer is then etched back in an uniform manner by a wet or dry planarization etch. The planarization etch is stopped once a selected portion 38 of electrode metallization layer 36 is exposed as illustrated in Figure 1(E). The extent of selected portion 38 is chosen to provide the desired overlap of the source and drain electrodes over the gate electrode after the etching steps described below.

Electrode metallization layer 36 is then selectively etched in the area of selected portion 38 to remove the portions of electrode metallization layer 36 and doped silicon contact layer 34 that substantially underlie exposed portion 38 to expose the top surface of channel plug 32', producing the structure shown in Figure 1(F). This self aligned source/drain configuration separates the source and drain regions of amorphous silicon contact layer 34 in the vicinity of the channel region of the TFT, although the layer remains intact in regions remote from the channel region of the TFT that are still covered by the gate metallization layer. After the source/drain contact configuration is formed, the retained portions of the planarization layer are removed.

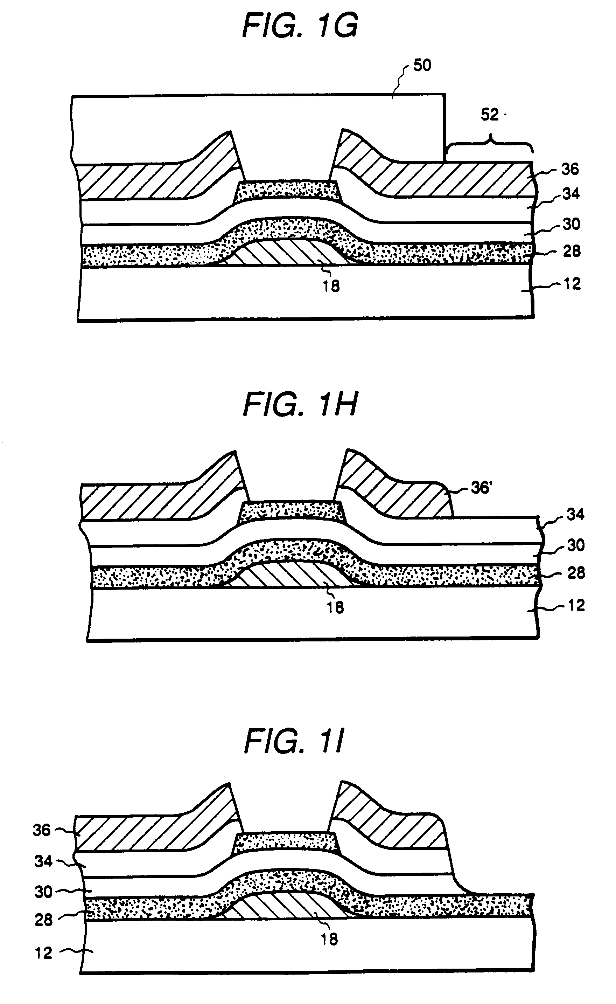

After the planarization process set forth above is completed, defining the access electrode structure is next undertaken by patterning the remaining electrode metallization layer. In accordance with this invention, the patterned electrode metallization layer is then used as a mask to etch the successive layers of the doped silicon contact layer and i-Si semiconducting layer in the area from which the electrode metallization layer has been removed. For example, in forming the access electrode configuration, a layer of photoresist 50 is deposited over the structure, exposed to radiation in accordance with a selected pattern, and developed to leave a retained portion as a mask for use in etching away the remaining electrode metallization layer on the wafer except in the area of the access electrode configuration. For example, as is illustrated in Figure 1(G), photoresist layer 50 is deposited and then photolithographically patterned and developed to provide windows 52 in those locations where the electrode metallization layer is to be removed in order to isolate different transistors and to form the areas around the access electrodes. The areas of electrode metallization layer 36 exposed by windows 52 are then etched away using known wet or dry etching techniques for producing sloped sidewalls 36', leaving a device structure as appears in Figure 1(H).

In accordance with the present invention, now-exposed portions of doped silicon contact layer 34, and the portions of i-Si semiconductor layer 30 lying beneath the exposed area of contact layer 34, are etched using the patterned electrode metallization layer, and optionally the retained portion of photoresist layer 50, as a mask. Known wet or dry etching techniques are preferably used to leave a sloped sidewall substantially contiguous with and having the same slope as the sidewall of the electrode metallization layer used as a mask. After completion of this step, the structure of the device appears as is illustrated in Figure 1(I).

The process of fabricating the thin film transistors is now completed. The use of the same mask for the patterning of the electrode metallization and the semiconductor material eliminates at least one photolithographic masking step from the prior art fabrication process, thereby simplifying the process and resulting in a higher yield of functional devices.

For thin film transistors which are part of a structure which requires a connection between the thin film transistor and a transparent conducting oxide (TCO) electrode, such as a liquid crystal display device, the TCO electrode is formed following the fabrication of the TFT and after the doped silicon and i-Si contact layers have been removed. The TCO electrode is typically formed by depositing the TCO uniformly over the structure, depositing and selectively exposing a photoresist layer to create a mask for removing the TCO from areas over which the TCO electrode will not extend, and etching the exposed TCO and removing the retained photoresist. As is illustrated in Figure 3, the sloped sidewalls of the source/drain electrode metallization layer, the contact layer, and the semiconductor layer facilitate high quality, conformal deposition of the thin TCO electrode layer 70 up the sidewalls and the source/drain metallization and onto its upper surface to provide good ohmic contact between the source/drain electrodes and the thin TCO electrode.

While the semiconductor material in the above described embodiment is amorphous silicon, since that is the material presently in typical use for thin film transistors, it should be understood that this process is equally applicable to the use of other semiconductor materials or other forms of silicon. Other semiconductor materials which are presently used in an amorphous condition are germanium and cadmium selenide. This process technique is applicable to those amorphous silicon semiconductor materials and any others as well as being applicable to polycrystalline or even monocrystalline semiconductor materials where the underlying support structure facilitates the formation of such semiconductor layers. Further, while the gate dielectric layer has been described as being silicon nitride, it will be understood that more than one sublayer may be present in the gate dielectric layer and that various sublayers may have different compositions, while a single layer dielectric may alternatively be comprised of another dielectric material, such as $SiO_2$

While only certain preferred features of the invention have been illustrated and described herein, many modifications and changes will occur to those skilled in the art. It is, therefore, to be understood that the appended claims are intended to cover all such modifications and changes as fall within the true spirit of the invention.

## Claims

1. A method of fabricating a thin film transistor (TFT) device structure, comprising the steps of:

    forming a gate electrode of metal on a substrate in a manner that leaves portions of said substrate not covered by gate metal;

    depositing a first dielectric layer over said gate metal and portions of said substrate not covered by said gate metal;

    depositing a semiconductor layer comprising substantially intrinsic silicon over said first dielectric layer;

    depositing a second dielectric layer over said intrinsic silicon layer;

    patterning said second dielectric layer to define a source/drain electrode gate overlap area;

    depositing a doped-silicon contact layer over the device structure;

    depositing an electrode metallization layer over said doped-silicon contact layer;

    forming a source/drain contact configuration and an associated access electrode configuration in said electrode metallization layer; and

    etching said doped-silicon and said intrinsic silicon layers to remove each of said silicon layers from said structure where said silicon layers do not underlie the configured electrode metallization layer.

2. A method of fabricating a thin film display device structure comprising the steps of:

    forming a gate electrode of metal on a substrate in a manner that leaves portions of said substrate not covered by gate metal;

    depositing a first dielectric layer over said gate metal and portions of said substrate not covered by said gate metal;

    depositing a semiconductor layer comprising substantially intrinsic silicon over said first dielectric layer;

    depositing a second dielectric layer over said intrinsic silicon layer;

    patterning said second dielectric layer to define a source/drain electrode gate overlap area;

    depositing a doped-silicon contact layer over the device structure;

    depositing an electrode metallization layer over said doped-silicon contact layer;

    forming a source/drain contact configuration and an associated access electrode configuration in said electrode metallization layer;

    etching said doped-silicon and said intrinsic silicon layers to remove each of said silicon layers from said structure where said silicon layers do not underlie the configured electrode metallization layer; and

    forming a transparent conducting oxide (TCO) electrode layer on said structure, said TCO layer being electrically coupled to said source drain contact configuration.

3. The method of claim 1 or 2 wherein said step of forming a source/drain contact configuration and an associated access electrode configuration for said structure comprises the steps of:

    depositing a planarization layer over said structure;

    uniformly etching said planarization layer to expose a selected portion of said electrode metallization layer;

    etching the exposed electrode metallization layer and said doped silicon layer disposed thereunder to shape said source/drain contact configuration; and

    patterning the remaining electrode metallization layer to shape said associated access electrode configuration.

4. The method of claim 3 wherein said step of forming a source/drain contact configuration and an associated access electrode configuration for said structure comprises photolithographically patterning said electrode metallization layer.

5. The method of claim 4 wherein said step of forming a gate electrode on said substrate comprises depositing a first conductive layer, depositing a second conductive layer over said first conductive layer, and patterning said first and second conductive layers.

6. The method of claim 5 wherein each of said patterning steps comprises:

    depositing a layer of photoresist;

    exposing said photoresist to actinic radiation In accordance with a desired pattern, and developing said photoresist so that photoresist retained in said layer provides the selected pattern for etching the underlying structure; and

    etching the underlying TFT structure not covered by the retained photoresist.

7. The method of claim 1 or 2 wherein said step of depositing said electrode metallization layer comprises depositing a first metallization layer and depositing a second metallization layer thereover.

8. The method of claim 1 or 2 further comprising the step of depositing a conductive protective capping layer over said doped silicon layer prior to the deposition of said electrode metallization layer.

9. The method of claim 1 or 2 wherein said step of etching said doped silicon and said intrinsic silicon layers includes etching said layers to form substantially contiguous sloped sidewalls extending between said configured electrode metallization layer and the layer underlying said intrinsic silicon semiconductor layer,

10. The method of claim 9 including the step of electrically coupling said TCO electrode layer to said source/drain contact configuration by depositing said TCO electrode layer over said substantially contiguous sloped sidewalls and at least a portion of said configured electrode metallization layer.

## FIG. 1A

## FIG. 1B

## FIG. 1C

## FIG. 1D

## FIG. 1E

## FIG. 1F

## FIG. 1G

50

52

36
34
30
28
18
12

## FIG. 1H

36'
34
30
28
18
12

## FIG. 1I

36
34
30
28
18
12

## FIG. 2

## FIG. 3